# EUROPEAN PATENT APPLICATION

(11) **EP 3 961 730 A1**
(43) Date of publication of application: **02.03.2022**
(21) Application number: 20794274.9
(22) Date of filing: 08.04.2020
(51) Int. Cl.: H01L 31/18, H01L 31/0236, H01L 31/0368, H01L 31/05

(54) **METHOD FOR MANUFACTURING SOLAR CELL**

(30) Priority: 25.04.2019 KR 20190048780
(71) Applicant: LG Electronics Inc., Seoul 07336 (KR)
(72) Inventor: LEE, Daeyong, Seoul 06772 (KR); KIM, Jinsung, Seoul 06772 (KR)
(74) Representative: Katérle, Axel
(86) International application number: PCT/KR2020/004758
(87) International publication number: WO 2020/218757

(57) **Abstract**

A manufacturing method of an embodiment according to the present invention may comprise the steps of: locating a solar cell, including a semiconductor substrate and a semiconductor layer which has an absorption coefficient higher than that of the semiconductor substrate and is formed on at least one side of the semiconductor substrate, such that the semiconductor layer is oriented toward a laser; emitting a laser beam toward the semiconductor layer to form a groove on the solar cell; and dividing the solar cell along the groove into a plurality of pieces.

## Description

### [Technical Field]

The present disclosure relates to a method for fabricating a solar cell that reduces thermal damage when the solar cell is divided into multiple sections.

### [Background Art]

As conventional energy resources like petroleum and coal are expected to become depleted in recent years, much interest is being paid on alternative energy sources to replace them and therefore solar cells used to produce electrical energy from solar energy are attracting attention.

A typical solar cell is made with semiconductor portions of different conductive types such as p-type and n-type that form a p-n junction and electrodes connected to the semiconductor portions of different conductive types. With this configuration, multiple solar cells are combined to form a solar cell module to generate electricity and obtain electrical power.

As a way of improving the power generation efficiency of solar cells, a method has been proposed to fabricate a solar cell module by dividing a finished solar cell fitted with all necessary components into multiple sections and interconnecting them.

When dividing a solar cell into multiple sections, a semiconductor scribing process is employed since the solar cell is a semiconductor. The scribing process refers to a process of forming a groove in the surface of a wafer by a diamond cutter, laser, etc. in order to cut up the wafer into individual chips.

One of the well-known scribing processes involves forming a groove by hitting one surface of a solar cell with a laser along a scribing line and physically dividing the solar cell into multiple sections along the groove.

However, the solar cell is thermally damaged when hit with a laser due to the high energy of the laser, which leads to a decrease in the efficiency of the solar cell.

### [Detailed Description of Invention]

### [Technical Problem]

The present disclosure has been devised in view of the foregoing circumstances, and one aspect of the present disclosure is to reduce thermal damage that occurs as a solar cell is hit with a laser.

### [Technical Solution]

A method for fabricating a solar cell according to an exemplary embodiment of the present disclosure may comprise: positioning a semiconductor substrate and a semiconductor layer with a higher absorption coefficient than the semiconductor substrate in such a manner that the semiconductor layer faces a laser in a solar cell formed on at least one side of the semiconductor substrate; forming a groove in the solar cell by directing the laser toward the semiconductor layer; and dividing the solar cell into multiple sections along the groove.

The groove may be formed through the semiconductor layer and even as far as part of the semiconductor substrate, and the depth of the groove may be 30 % to 70 % of the thickness of the semiconductor substrate.

The groove may be formed along the center line of the solar cell so as to divide the solar cell into two sections, or a plurality of grooves may be formed in the solar cell so as to divide the solar cell into three or more sections.

When the laser has a wavelength of 1024 nm, the semiconductor layer may be 600 nm thick or thicker, and, when the laser has a wavelength of 532 nm, the semiconductor layer may be 180 nm thick or thicker.

The semiconductor layer may be polycrystalline silicon, and the semiconductor substrate may be monocrystalline silicon.

The semiconductor layer may be formed on the back surface of the semiconductor substrate.

The semiconductor layer may comprise a first conductive region containing a first conductive dopant of the opposite polarity to that of the semiconductor substrate and a second conductive region containing a second conductive dopant of the same polarity as the semiconductor substrate, and the groove may be formed in the second conductive region.

The semiconductor layer may comprise a first conductive dopant of the opposite polarity to that of the semiconductor substrate, and a control passivation layer may be formed between the semiconductor layer and the semiconductor substrate.

### [Advantageous Effects]

According to an exemplary embodiment of the present disclosure, it is possible to reduce thermal damage to the semiconductor substrate because of a semiconductor layer functioning as a layer that absorbs part of the energy of a laser hitting the solar cell.

The semiconductor layer may be configured as a semiconductor layer having a higher absorption coefficient than the semiconductor substrate, and, especially in the present disclosure, one of the existing components, i.e., a semiconductor layer configured as a polycrystalline silicon layer, may be used without adding a new layer to the solar cell.

### [Description of Drawings]

FIG. 1 is a view schematically illustrating a process of forming a groove in a solar cell in order to divide the solar cell into multiple sections according to an exemplary embodiment of the present disclosure.
FIG. 2 is a flowchart illustrating a fabrication method according to an exemplary embodiment of the present disclosure.
FIG. 3 is a graph showing how the absorption coefficient varies depending on the crystallinity of different types of silicon.
FIG. 4 is a graph showing test results on the cutting depth of a groove based on the presence or absence of a semiconductor layer made of polycrystalline silicon.
FIG. 5 is a graph showing a decrease in the power output of the solar cell relative to stored pulse energy.
FIG. 6 is a graph showing how the absorption depth varies depending on the crystallinity of different types of silicon.
FIGS. 7 and 8 are views for explaining a laser that forms a groove in a solar cell.
FIG. 9 is a view showing a configuration of a solar cell according to an exemplary embodiment to which the present disclosure is applicable.
FIG. 10 is a view showing a cross-section of the solar cell shown in FIG. 9.
FIG. 11 shows another embodiment of a solar cell to which the fabrication method of the present disclosure is applicable.

### [Mode for Invention]

Reference will now be made in detail to various embodiments of the disclosure, examples of which are illustrated in accompanying drawings. The disclosure may, however, be embodied in many alternate forms and should not be construed as limited to the embodiments set forth herein.

In the drawings, illustration of parts unrelated to embodiments of the disclosure is omitted for clarity and simplicity of description. The same reference numerals designate the same or very similar elements throughout the disclosure. In the drawings, thicknesses, widths or the like of elements are exaggerated or reduced for clarity of description, and should not be construed as limited to those illustrated in the drawings.

It will be further understood that, throughout this specification, when one element is referred to as "comprising" another element, the term "comprising" specifies the presence of another element but does not preclude the presence of other additional elements, unless context clearly indicates otherwise. In addition, it will be understood that when one element such as a layer, a region or a plate is referred to as being "on" another element, the one element may be directly on the another element, and one or more intervening elements may also be present. In contrast, when one element such as a layer, a region or a plate is referred to as being "directly on" another element, one or more intervening elements are not present.

Moreover, if the thickness, width, or length of a certain constituent element is the same as the thickness, width, or length of another constituent element, it means that the two constituent elements have the same thickness, width, or length within a margin of process error.

Therefore, if the margin of process error is 10 %, it means that their thicknesses are considered the same within the margin of process error of 10 %. The following description will be given based on the assumption that the margin of process error is 10 %.

In addition, one side of a semiconductor substrate and the other side refer to opposing sides of the plane of the semiconductor substrate. Accordingly, for example, if one side of a semiconductor substrate is the front side of the semiconductor substrate on which light falls, the other side of the semiconductor substrate refers to the back side of the semiconductor substrate. Conversely, if one side of the semiconductor substrate is the back side of the semiconductor substrate, the other side of the semiconductor substrate may refer to the front side of the semiconductor substrate.

For convenience of explanation, the following description will be made based on the assumption that one side of a semiconductor substrate is the front side of the semiconductor substrate and the other side of the semiconductor substrate is the back side of the semiconductor substrate.

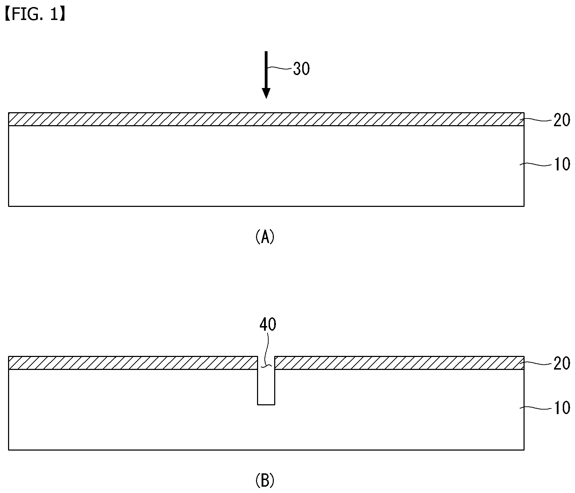

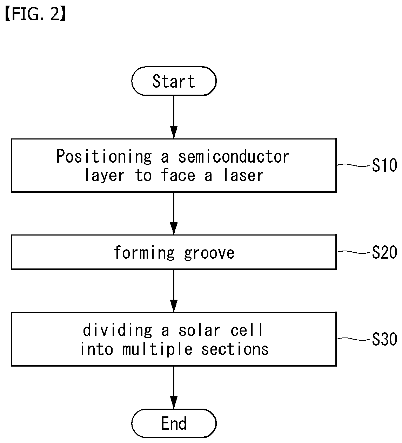

FIG. 1 is a view schematically illustrating a process of forming a groove in a solar cell in order to divide the solar cell into multiple sections according to an exemplary embodiment of the present disclosure. FIG. 2 is a flowchart illustrating a fabrication method according to an exemplary embodiment of the present disclosure.

As used herein, the term "solar cell" refers to a finished product, like solar cells 100 and 1000 to be described later, which comprises a plurality of components used to generate electric power on a semiconductor substrate - for example, a semiconductor substrate, a control passivation layer, first and second conductive regions containing impurities, an intrinsic semiconductor portion, an insulating layer, a back passivation layer, and first and second electrodes. The term "groove" refers to a groove formed by hitting a solar cell with a laser in order to divide the solar cell into multiple sections.

Referring to FIGS. 1 and 2, a solar cell 100 according to an exemplary embodiment of the present disclosure may comprise a semiconductor substrate 10 and a semiconductor layer 20 formed by at least one side of the semiconductor substrate 10.

The semiconductor substrate 10 may be made of at least one of monocrystalline silicon and polycrystalline silicon doped with a first or second conductive dopant. In an example, the semiconductor substrate 10 may be made by doping a monocrystalline silicon wafer with a first or second conductive dopant at a low concentration.

Here, the first conductive dopant may be either a p-type or n-type dopant, and the second conductive dopant may be the other dopant. Concretely, if the first conductive dopant is a p-type, which is one of trivalent atoms such as boron (B), aluminum (Al), gallium (Ga), and indium (In), the second conductive dopant may be an n-type, which is one of pentavalent atoms such as phosphorus (P), arsenic (As), bismuth (Bi), and antimony (Sb). Accordingly, in an example, either the first or second conductive dopant may be boron (B), and the other one may be phosphorus (P).

The semiconductor substrate 10 may have a thickness that takes up 90 % of the entire thickness of the solar cell, and, in a preferred embodiment, the thickness of the semiconductor substrate 10 may be substantially 160 *µ*m. Here, the thickness is considered substantially the same within a margin of process error of ±10 %.

Moreover, the semiconductor layer 20 may be formed over an entire side of the semiconductor substrate 10, and may be made of a semiconductor material with a higher absorption coefficient than the semiconductor substrate 10. In an example, if the semiconductor substrate 10 is monocrystalline silicon, the semiconductor layer 20 may be polycrystalline silicon which has a higher absorption coefficient than the monocrystalline silicon.

The semiconductor layer 29 may act as a functional layer that, when the semiconductor substrate 10 is hit with a laser, prevents thermal damage to the semiconductor substrate 10 caused by the high energy of the laser by partially absorbing the laser light. The thickness of the semiconductor layer 20 may be set in consideration of absorption depth, in order to function as an effective absorption layer, which will be described later in details.

In addition, the semiconductor layer 20 may have a predetermined thickness so as to function as one layer constituting the solar cell. In an example, the semiconductor layer 20 may be configured as a layer where a conductive region is formed, in which case the semiconductor layer 20 may have a thickness of 250 to 300 *µ*m. Once the semiconductor layer 20 is configured as one layer constituting the solar cell, it may function as an absorption layer when the solar cell is divided, thus preventing degradation of the solar cell and contributing to the improvement of productivity since there is no need to add a new component to the solar cell.

Meanwhile, although FIG. 1 illustrates that the semiconductor layer 20 is formed directly on one surface of the semiconductor substrate 10, the present disclosure is not limited to this but another layer may intervene between these two layers. Here, the term "directly" indicates that one surface of the semiconductor layer 20 is formed on one surface of the semiconductor substrate 10, with no intervening layer between the semiconductor layer 20 and the semiconductor substrate 10.
(A) of FIG. 1 illustrates that the semiconductor substrate 10 is hit with a laser 30. According to the fabrication method of the present disclosure, it is desirable that the laser 30 is shone first on the semiconductor layer 20 and then on the semiconductor substrate 10, rather than being shone directly on the semiconductor substrate 10 in terms of time. In an example, the semiconductor layer 20 may be positioned to face the laser 30 (S10), and the laser 30 may be directed toward the semiconductor substrate 10 vertically upright from the semiconductor layer 20 (S20).
   Various types of lasers generally available in the market may be used as the laser 30. In an example, the laser 30 may be a 532 nm laser or 1024 nm laser depending on the wavelength of the laser light, and, in some lasers, the thickness of the semiconductor layer 20 may be adjusted.
(B) of FIG. 1 shows the groove 40 formed by the irradiation of the laser 30. When the semiconductor substrate 10 is irradiated with a laser, laser ablation occurs as a local region irradiated with the laser is heated, thereby forming the groove 40. In one exemplary embodiment of the present disclosure, however, the laser 30 is shone on the semiconductor substrate 10 after passing through the semiconductor layer 20 which has a higher absorption coefficient than the semiconductor substrate 10, and part of the laser light is therefore absorbed by the semiconductor layer 20, thus reducing thermal damage to the semiconductor substrate 10. The effects of this will be described in details with reference to other drawings.

After the groove 40 is formed on one surface of the solar cell 100, the solar cell 100 may be divided into multiple sections by applying a physical impact on the solar cell 100 (S30).

Preferably, the depth dt of the groove 40 formed in the solar cell 100 is 30 % to 70 % of the thickness ds of the solar cell 100. Here, the thickness ds of the solar cell 100 may be substantially equal to the thickness of the semiconductor substrate since the thickness of the layer overlying the semiconductor substrate is very small compared to the thickness of the semiconductor substrate. If the depth dt of the groove 40 is less than 30 % of the thickness ds, the solar cell may not be split along the groove 40 but cracked when the solar cell is divided along the groove 40 into multiple sections. If the depth dt of the groove 40 is greater than 70 % of the thickness ds, this may cause severe thermal damage to the solar cell 100 in the process of forming the groove 40, which may lead to a drastic decrease in the efficiency of the solar cell.

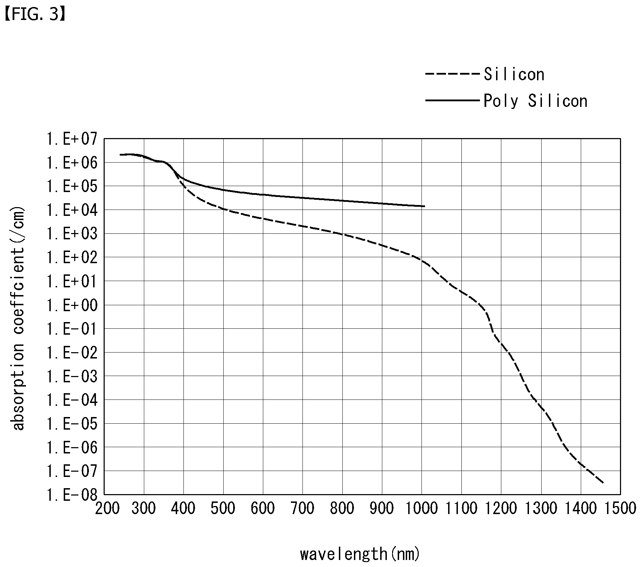

FIG. 3 is a graph showing how the absorption coefficient varies depending on the crystallinity of different types of silicon. In FIG. 3, silicon shows the light absorption coefficient vs. the wavelength of monocrystalline silicon, and polysilicon shows the light absorption coefficient vs. the wavelength of polycrystalline silicon.

The graph shows that there is no difference in absorption coefficient between the monocrystalline silicon and the polycrystalline silicon at a wavelength of around 400 nm or shorter. From this, it can be seen that the semiconductor layer 20 cannot function as an absorption layer when a laser with a wavelength of 400 nm or shorter is used, thus making it difficult to reduce thermal damage to the semiconductor substrate 10.

Moreover, the graph clearly shows that, at a wavelength of 400 nm or longer, the absorption coefficient of the polycrystalline silicon becomes higher than that of the monocrystalline silicon as the wavelength increases. As such, the polycrystalline silicon absorbs laser light better than the monocrystalline silicon if a laser with a wavelength of 400 nm or longer is used, and, as a result, thermal damage to the semiconductor substrate 10 may be reduced.

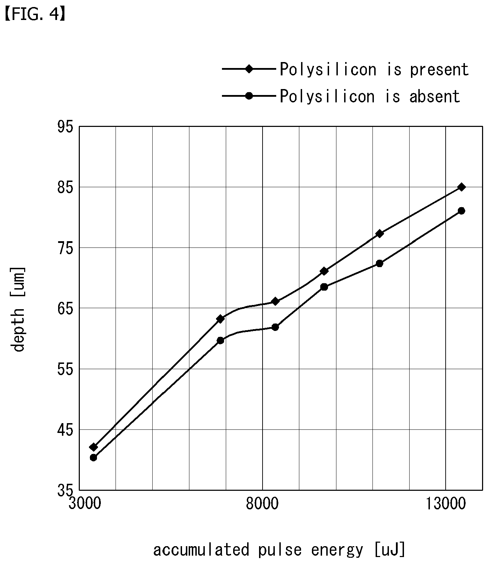

Meanwhile, FIG. 4 is a graph showing test results on the cutting depth of a groove based on the presence or absence of a semiconductor layer made of polycrystalline silicon. Here, the stored pulse energy on the x axis represents the total energy of the laser shone on the solar cell.

As can be seen from the graph of FIG. 4, the cutting depth linearly increases with increasing stored pulse energy. Also, it can be seen that, with the same stored pulse energy, the groove is formed deeper when the laser is shone on the solar cell with the semiconductor layer, compared to when the laser is shone on the solar cell with no semiconductor layer.

These test results indicate that, when a groove is formed in a solar cell with the semiconductor layer, the depth of the groove may be the same as in a solar cell with no semiconductor layer, if the solar cell with the semiconductor layer is hit with a lower-energy laser than the solar cell with no semiconductor layer. As a result, this may lead to less thermal damage to the solar cell with the semiconductor layer.

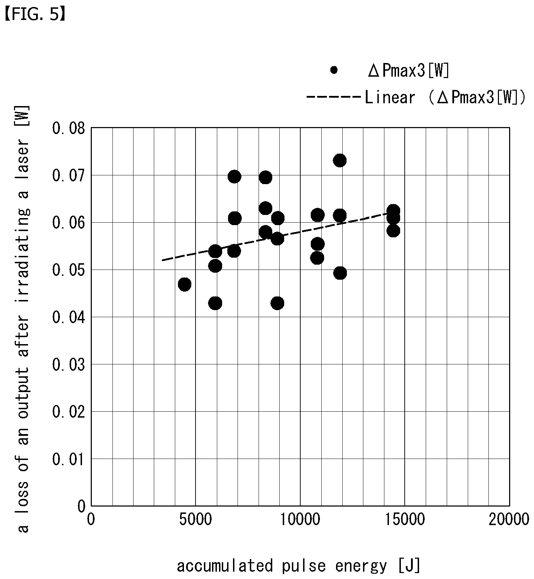

This can be clearly seen through FIG. 5. FIG. 5 is a graph showing a decrease in the power output of the solar cell relative to stored pulse energy.

As shown in the drawing, it can be seen that the power output of the solar cell decreases linearly with increasing stored pulse energy. These results, when applied to FIG. 3, show that the solar cell with the semiconductor layer has less thermal damage than the solar cell with no semiconductor layer.

Table 1 below shows the requirements of the laser used in the above-mentioned tests of FIGS. 4 and 5, and the laser was scanned 10 times.

**[Table 1]**

| LASER Wavelength [nm] | Frequency [kHz] | Scan Speed [m/sec] | LASER Power [W] | Pulse energy [uJ] | Total Number of Shots [1E3 ea] | Stored Pulse Energy [J] |
|---|---|---|---|---|---|---|
| 532 | 300 | 2.6 | 11.2 | 37.3 | 224 | 8351 |

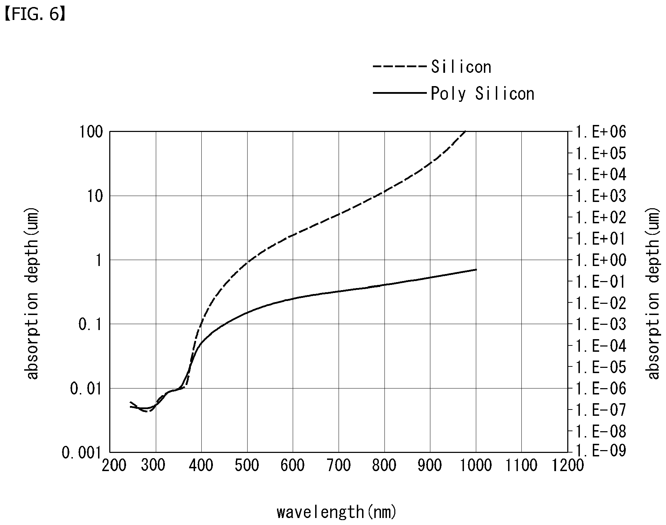

FIG. 6 is a graph showing how the absorption depth varies depending on the crystallinity of different types of silicon. The absorption depth is defined as "1/absorption coefficient", which refers to a depth of transmission from an incident surface at which around 36 % of the energy of the shone light can be absorbed. As can be seen from the graph, the absorption coefficient linearly increases with increasing wavelength, and the monocrystalline silicon has a better absorption coefficient than the polycrystalline silicon at the same wavelength.

Meanwhile, FIG. 3 shows that, at a wavelength of 400 nm or longer, the absorption coefficient of the polycrystalline silicon is higher than that of the monocrystalline silicon. In view of this, it is preferable to use a laser with a wavelength or 400 nm or longer in one exemplary embodiment of the present disclosure; more preferably, a laser with a wavelength of 532 nm (hereinafter, a 532 laser) and a laser with a wavelength of 1024 nm (hereinafter, a 1024 laser) may be used.

However, as shown in FIG. 6, the polycrystalline silicon absorbs 36 % of the light with a wavelength of 532 nm if the thickness of the semiconductor layer 20 is 180 nm. Accordingly, in the solar cell with the configuration shown in FIG. 1, if the semiconductor layer 20 has a thickness of 180 nm or more, around 36 % of the laser light is absorbed by the semiconductor layer 20, and the rest is projected on the semiconductor substrate 10, thereby reducing thermal damage to the semiconductor substrate 10.

In comparison to this, when the 532 laser is shone directly on the monocrystalline silicon, the same effect can be obtained only when the semiconductor layer 20 is at least 1280 nm thick.

That is, in one exemplary embodiment of the present disclosure, it is possible to effectively reduce thermal damage caused by laser by forming the semiconductor layer 20 over the semiconductor substrate 10.

When the 1024 laser is used, the polycrystalline silicon absorbs 36 % of the light if it is 600 nm thick. Accordingly, in the solar cell with the configuration shown in FIG. 1, the semiconductor layer 20 needs to be 600 nm thick or thicker, in order to effectively reduce thermal damage to the semiconductor substrate 10.

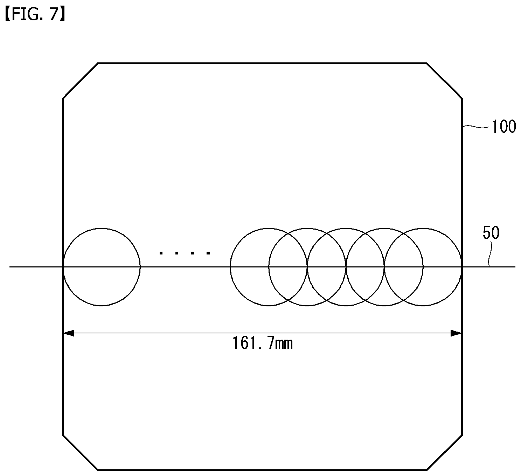

FIG. 7 is a view for explaining a laser that forms a groove in a solar cell.

The laser may be classified as a linear laser or a pulse-type laser. The linear laser oscillates incessantly on the time axis. When the linear laser is used to form a groove, the solar cell is heated without an idle period (cooling period), and thermal damage accumulates on the solar cell along the time axis, which is not desirable.

In comparison to this, the pulse-type laser intermittently shines laser light in sync with an oscillation frequency with a pulse. Thus, the solar cell may alternate between a heating period and a cooling period, thereby effectively reducing thermal damage compared to the linear laser.

In the pulse-type laser, one shot from the laser is referred to as a spot 60, and laser light is projected during a scan time. Here, the scan time denotes a period of time over which laser light is projected along a scribing line 50.

When forming a groove, it is better to form a groove through multiple scans than through one scan, in order to reduce thermal damage to the solar cell.

The number of scans may be adjusted by the pulse energy. The pulse energy is the amount of energy of one shot from the laser. The total stored pulse energy used to form a groove may be obtained by multiplying the pulse energy uJ with the total number of shots, and the depth of the groove and the maximum power Pmax of the laser are determined by the total stored pulse energy.

A laser scans the solar cell along a scan line (or scribing line) 50. One groove line may be formed on the surface of the solar cell through around 10 scans, and the number of scans may be adjusted by parameters such as scan speed and pulse energy.

FIG. 7 illustrates that a scan line 50 is formed along the center line of the solar cell 100 so as to divide the solar cell 100 into two sections. Here, the expression "divide the solar cell into two sections" refers to dividing the solar cell into two pieces in such a manner that the two pieces are equal in width (vertical length based on the drawing).

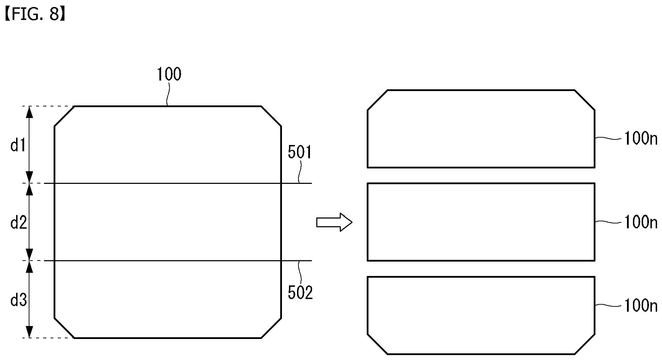

In an exemplary embodiment of the present disclosure, the solar cell 100 may be divided into n sections as illustrated in FIG. 8. Here, n is an integer, and the n in FIG. 8 is 3, for example. Referring to FIG. 8, a first scan line 501 may be positioned in the upper part of the solar cell, and a second scan line 502 may be positioned in the lower part of the solar cell, so that the solar cell 100 is divided into three sections. Here, after the solar cell is divided, a first width d1 between an edge of the solar cell and the first scan line 501, a second width d2 between the first scan line 501 and the second scan line 502, and a third width d3 between the second scan line 502 and the other edge of the solar cell may be equal.

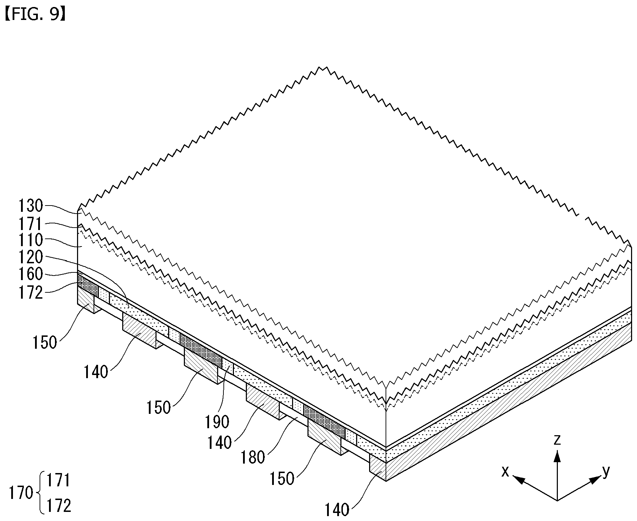

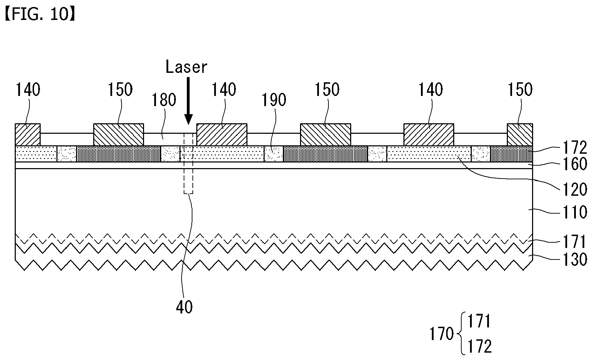

Laser light is shone along the first scan line 501 and the second scan line 502 as described above. As a result, two groove lines are formed on the surface of the solar cell, and the solar cell may be divided into first to third solar cell pieces lOOn by applying a physical impact on the solar cell. Hereinafter, a solar cell to which the above-described fabrication method of the present disclosure is applicable will be described. FIG. 9 is a view showing a configuration of a solar cell according to an exemplary embodiment to which the present disclosure is applicable. FIG. 10 is a view showing a cross-section of the solar cell.

Referring to these drawings, an example of the solar cell may comprise a semiconductor substrate 110, control passivation layers 132 and 160, a first conductive region 170, a second conductive region 120, an intrinsic semiconductor portion 190, an insulating layer 130, a back passivation layer 180, a plurality of first electrodes 140, and a plurality of second electrodes 150.

The semiconductor substrate 110 may be made of at least one of monocrystalline silicon and polycrystalline silicon doped with a first or second conductive dopant. In an example, the semiconductor substrate 110 may be made by doping a monocrystalline silicon wafer with a first or second conductive dopant at a low concentration.

Here, the first conductive dopant may be either a p-type or n-type dopant, and the second conductive dopant may be the other dopant.

Concretely, if the first conductive dopant is a p-type, which is one of trivalent atoms such as boron (B), aluminum (Al), gallium (Ga), and indium (In), the second conductive dopant may be an n-type, which is one of pentavalent atoms such as phosphorus (P), arsenic (As), bismuth (Bi), and antimony (Sb).

Accordingly, in an example, either the first or second conductive dopant may be boron (B), and the other one may be phosphorus (P).

The control passivation layers 132 and 160 may be placed in direct contact with the entire back surface of the semiconductor substrate 110, and may comprise a dielectric material.

The control passivation layers 132 and 160 may allow carriers generated in the semiconductor substrate 110 to pass through, and may perform a passivation function on the back surface of the semiconductor substrate 110. To this end, the control passivation layers 132 and 160 may be made to a thickness of 0.5 nm to 2 nm.

The control passivation layers 132 and 160 may be made of a dielectric material such as SiCx or SiOx.

The first conductive region 170 may be formed on the front or back surface of the semiconductor substrate 110, and may comprise the same conductive region as the semiconductor substrate 110.

In an example, the first conductive region 170 may refer to a region that is doped with the same dopant as the conductive dopant of the semiconductor substrate 110 at a lower concentration than the dopant concentration of the semiconductor substrate 110.

In an example, the first conductive region 170 may comprise a front electric field portion 171 and a back electric field portion 172.

The front electric field portion 171 may be formed over the entire front surface of the semiconductor substrate 110, and may be doped with the same conductive dopant as the semiconductor substrate 110 at a high concentration.

In an example, the front electric field portion 171 may be formed by diffusing a conductive dopant within the front surface of the semiconductor substrate 110 by thermal diffusion. Thus, the front electric field portion 171 may be made of the same silicon material as the semiconductor substrate 110.

In an example, if the semiconductor substrate 110 is made of monocrystalline silicon, the front electric field portion 171 also may be made of monocrystalline silicon.

The back electric field portion 172 may run lengthwise parallel to the second conductive region 120 on the back surface of the semiconductor substrate 110, and may be made of polycrystalline silicon doped with the same conductive dopant as the semiconductor substrate 110 at a high concentration. As such, the back electric field portion 172 may perform its function.

In an example, the back electric field portion 172 may be formed in direct contact with the back surfaces of the control passivation layers 132 and 160, and may be spaced apart from the second conductive region 120.

The second conductive region 120 may run lengthwise parallel to the back electric field portion 172 on the back surface of the semiconductor substrate 110, and may be doped with the conductive dopant opposite to that of the semiconductor substrate 110 and form a p-n junction with the semiconductor substrate 110, with the control passivation layer 132 in between. As such, the second conductive region 120 may function as an emitter portion.

The intrinsic semiconductor portion 190 may be formed in the space between the back electric field portion 172 of the first conductive region 170 and the second conductive region 120, in the area above the back surface of the control passivation layer 132. Unlike the first conductive region 170 and the second conductive region 120, the intrinsic semiconductor portion 190 may be made of an intrinsic polycrystalline silicon layer not doped with the first conductive dopant or second conductive dopant.

In this way, the back electric field portion 172 of the first conductive region 170, the second conductive region 120, and the intrinsic semiconductor portion 190, which are positioned above the control passivation layer 132, may be made of a silicon material having a different crystallinity from the silicon material of the semiconductor substrate 110, and, as described above, they may be formed as a semiconductor layer that functions as an absorption layer in the laser process. In this case, one of the existing components may function as the absorption layer without configuring an additional layer in the solar cell. Therefore, it is possible to easily reduce thermal damage to the solar cell without increasing the fabrication costs and the number of fabrication processes.

In an example, if the semiconductor substrate 110 is made of monocrystalline silicon, for example, the semiconductor layer - that is, the back electric field portion 172 of the first conductive region 170, the second conductive region 120, and the intrinsic semiconductor portion 190 - may be made of a material with a higher absorption coefficient than the semiconductor substrate 110, for example, polycrystalline silicon, or a mixed material of polycrystalline silicon and amorphous silicon. If the back electric field portion 172 of the first conductive region 170 and the second conductive region 120 are made of polycrystalline silicon, their thicknesses may be determined depending on the wavelength of the laser used, as described above. If the laser has a wavelength of 532 nm, the semiconductor layer may have a thickness of preferably 180 nm or more. If the laser has a wavelength of 1024 nm, the semiconductor layer may have a thickness of preferably 600 nm or more.

The insulating layer 130 may be positioned on at least either one side or the other side of the semiconductor substrate 110. In an example, as shown in FIG. 1, the insulating layer 130 may be positioned on one side, i.e., the front surface, of the semiconductor substrate 110. However, this is not necessarily limited to FIG. 1, and, in some cases, the insulating layer 130 may be positioned on the other side, i.e., the back surface, of the semiconductor substrate 110 if the solar cell is a double-sided solar cell in which light falls not only on one side of the semiconductor substrate 110 but also on the other side.

Moreover, in a case where a conductive region such as the front electric field portion 171 is formed on the semiconductor substrate 110, as shown in FIG. 1, the insulating layer 130 may be positioned over the front electric field portion 171. However, in a case where the front electric field portion 171 is not formed, as opposed to FIG. 1, the insulating layer 130 may be placed in direct contact with the front surface of the semiconductor substrate 110.

Here, the one side of the semiconductor substrate 110 may be the front surface of the solar cell on which light falls directly from the semiconductor substrate 110, and the other side of the semiconductor substrate 110 may be the back surface of the solar cell positioned opposite the one side where light is reflected and falls.

The insulating layer 130 may minimize the reflectivity of light falling on the semiconductor substrate 110 from the outside, block UV rays from the outside, prevents etching of the insulating layer 130 caused by acetic acid produced due to moisture penetration into a sealing material such as EVA, one of the components of a solar cell module, prevent carriers generated in the substrate from getting lost due to UV rays, and boost the open voltage Voc and short-circuit current of the solar cell module, thereby enhancing the overall efficiency of the solar cell module.

The plurality of first electrodes 140 may be connected to the second conductive region 120 and run lengthwise. The first electrodes 140 may collect carriers that have migrated to the second conductive region 120.

The plurality of second electrodes 150 may be connected to the back electric field portion 172 of the first conductive region 170 and run lengthwise parallel to the first electrodes 140. The second electrodes 150 may collect carriers that have migrated to the first conductive region 170.

The back passivation layer 180 may be formed on the back surface of the back electric field portion 172 of the first conductive region 170, the back surface of the second conductive region 120, and the back surface of the intrinsic semiconductor portion 190, except the area where the first and second electrodes 140 and 150 are formed.

The back passivation layer 180 removes defects caused by dangling bonds formed on the back surface of the polycrystalline silicon layer formed in the second conductive region 120, first conductive region 170 and intrinsic semiconductor portion 190, thereby preventing carriers generated in the semiconductor substrate 110 from annihilating through recombination of the dangling bonds.

The solar cell applied to the solar cell module according to the present disclosure is not necessarily limited to FIG. 1, and changes may be made to the components, except that the first and second electrodes 140 and 150 in the solar cell are formed on the back surface of the semiconductor substrate 110.

For ex ample, the front electric field portion 171 of the first conductive region 170 may be omitted. In this case, the insulating layer 130 may be placed in direct contact with the front surface of the semiconductor substrate 110.

Meanwhile, it is desirable that, in the solar cell thus configured, a laser is shone on the opposite side (for example, back side) of a light-receiving surface. When a laser is shone on the semiconductor substrate 110, a groove 40 is formed as the surface of the semiconductor substrate 110 melted by the laser cools down. At this point, the area around the groove 40 too receives thermal energy due to the high heat of the laser, whereby stable bonds between crystals are broken, thus causing an increase in the number of recombination sites. For this reason, it is desirable that, when the solar cell is hit with a laser, the laser is shone not on the light-receiving surface of the semiconductor surface 110 but on the opposite side.

The back surface of the solar cell is configured to comprise the first conductive region 170 and the second conductive region 120, and the first conductive region 170 forms a p-n junction with the semiconductor substrate 110. Thus, it is desirable that a laser is not shone on the area where the p-n junction is formed. As is generally known, the solar cell produces electricity by a p-n junction between the semiconductor substrate and the emitter. By the way, the p-n junction area is damaged by the laser irradiation of the area where the emitter is formed, which inevitable leads to a decrease in the power generation efficiency of the solar cell.

In view of these, it is preferable that, in the present disclosure, a laser is not shone on the area where the emitter is formed. In an example, if the first conductive region 170 forms the emitter and the second conductive region 120 forms the back electric field portion, a laser may be shone on the back surface, i.e., the opposite side of the light-receiving surface, or on the area where the second conductive region 120 is formed so as to avoid the area where the emitter is formed. In this case, the laser may be shone in the lengthwise direction of the electrodes 140. The lengthwise direction of the electrodes 140 corresponds to the scanning direction of the laser in a case where the laser is shone on the second conductive region 120. Thus, the laser is configured not to run across metal electrodes, which offers the advantage of forming a groove in the solar cell without interference with the electrodes.

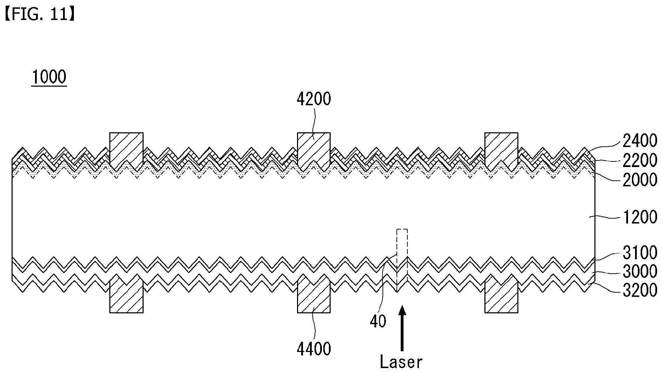

FIG. 11 shows another embodiment of a solar cell to which the fabrication method of the present disclosure is applicable. While the foregoing solar cell is a back contact solar cell in which light enters through the back surface of the solar cell, the solar cell according to this exemplary embodiment may be configured as a double-side light-receiving solar cell which is capable of receiving light entering through both the front and back surfaces.

The solar cell 1000 may comprise a semiconductor substrate 1200, conductive regions 2000 and 3000 formed in or on the semiconductor substrate 1200, and electrodes 4200 and 4400 connected to the conductive regions 2000 and 3000.

In an example, the conductive regions 2000 and 3000 may comprise a first conductive region 2000 and a second conductive region 3000 that are of different conductive types. The electrodes 4200 and 4400 may comprise a first electrode 4200 connected to the first conductive region 2000 and a second electrode 4400 connected to the second conductive region 3000.

The semiconductor substrate 1200 may comprise a first or second conductive dopant with a relatively low doping concentration, which may be a crystalline substrate, for example, either a monocrystalline or polycrystalline silicon substrate. In this case, at least one of the front and back surfaces of the semiconductor substrate 1200 may have a texturing structure or antireflection structure that has pyramid-shaped ridges so as to minimize reflection. The drawing illustrates a double-sided light-receiving solar cell in which ridges are formed on both the front and back surfaces.

The conductive regions 2000 and 3000 may comprise a first conductive region 2000 of first conductive type that is positioned on one side (for example, the front or back side) of the semiconductor substrate 1200 and a second conductive region 3000 of second conductive type that is positioned on another side (for example, the other side) of the semiconductor substrate 1200. The conductive regions 2000 and 3000 may be of a different conductive type from the semiconductor substrate 1200 or may have a higher doping concentration than the semiconductor substrate 1200.

In a preferred embodiment, the first conductive region 2000 functioning as the emitter may be configured as a doping region corresponding to part of the semiconductor substrate 1200 and therefore improve the characteristics of junctions with the semiconductor substrate 1200.

Also, it is desirable that the second conductive region 3000 functioning as the back electric field portion is configured as a semiconductor layer formed over the semiconductor substrate 1200, separately from the semiconductor substrate 1200. As described above, the semiconductor layer 3000 may be made of a material with a higher absorption coefficient than the semiconductor substrate 1200 so as to function as an absorption laser when a laser is projected - for example, if the semiconductor substrate 1200 is made of monocrystalline silicon, the second conductive region 3000 may be made of polycrystalline silicon.

As for the thickness of the second conductive region 3000, the semiconductor layer 3000 may have a thickness of 180 nm or more if the projected laser is a 532 laser and a thickness of 600 nm or more if the projected laser is a 1024 laser.

A first passivation layer 22 and/or antireflection layer 24, which is a first insulating film, may be positioned over (for example, make contact with) the front surface of the semiconductor substrate 12 (more precisely, the first conductive region 20 formed on the front surface of the semiconductor substrate 12). A second passivation layer 32, which is a second insulating film, may be positioned over (for example, make contact with) the back surface of the semiconductor substrate 12 (more precisely, the second conductive region 30 formed on the back surface of the semiconductor substrate 12). The antireflection layer 24 and the second passivation layer 32 may be made of various insulating materials. In an example, the first passivation layer 22, antireflection layer 24, or second passivation layer 32 may have a multi-layer film structure composed of a single film or two or more films selected from the group consisting of a silicon nitride film, a hydrogen-containing silicon nitride film, a silicon oxide film, a silicon oxide nitride film, an aluminum oxide film, a silicon carbide film, MgF2, ZnS, TiO2, and CeO2. However, the present disclosure is not limited to the above.

Moreover, a control passivation layer 3100 may be formed between the semiconductor substrate 1200 and the semiconductor layer 3000 to provide a tunneling effect. The control passivation layer 3100 may allow carriers generated in the semiconductor substrate 1200 to pass through, and may perform a passivation function on the back surface of the semiconductor substrate 1200. To this end, the control passivation layer 3100 may have a thickness of 0.5 nm to 2 nm.

The control passivation layer 300 may be made of a dielectric material such as SiCx or SiOx.

The first electrode 42 is electrically connected to the first conductive region 20 through an opening formed through the first insulating film, and the second electrode 44 is electrically connected to the second conductive region 30 through an opening formed through the second insulating film. The first and second electrodes 42 and 44 may be made of various conductive materials (for example, metals) and have various shapes.

Although the exemplary embodiments of the present disclosure have been described in detail, the scope of the present disclosure is not limited thereto and various modifications and improvements made by those skilled in the art by using the basic concept of the present disclosure defined in the claims also fall within the scope of the present disclosure.

## Claims

1. A method for manufacturing a solar cell, the method comprising:
positioning a semiconductor substrate and a semiconductor layer with a higher absorption coefficient than the semiconductor substrate in such a manner that the semiconductor layer faces a laser in a solar cell formed on at least one side of the semiconductor substrate;
forming a groove in the solar cell by directing the laser toward the semiconductor layer; and
dividing the solar cell into multiple sections along the groove.

2. The method of claim 1, wherein the groove is formed through the semiconductor layer and even as far as part of the semiconductor substrate.

3. The method of claim 1, wherein the depth of the groove is 30 % to 70 % of the thickness of the semiconductor substrate.

4. The method of claim 1, wherein the groove is formed along the center line of the solar cell so as to divide the solar cell into two sections.

5. The method of claim 1, wherein a plurality of grooves are formed in the solar cell so as to divide the solar cell into three or more sections.

6. The method of claim 1, wherein, when the laser has a wavelength of 1024 nm, the semiconductor layer is 600 nm thick or thicker.

7. The method of claim 1, wherein, when the laser has a wavelength of 532 nm, the semiconductor layer is 180 nm thick or thicker.

8. The method of claim 1, wherein the semiconductor layer is polycrystalline silicon, and the semiconductor substrate is monocrystalline silicon.

9. The method of claim 8, wherein the semiconductor layer is formed on the back surface of the semiconductor substrate.

10. The method of claim 9, wherein the semiconductor layer comprises a first conductive region containing a first conductive dopant of the opposite polarity to that of the semiconductor substrate and a second conductive region containing a second conductive dopant of the same polarity as the semiconductor substrate.

11. The method of claim 10, wherein the groove is formed in the second conductive region.

12. The method of claim 9, wherein the semiconductor layer comprises a first conductive dopant of the opposite polarity to that of the semiconductor substrate.

13. The method of claim 10 or 12, wherein a control passivation layer is formed between the semiconductor layer and the semiconductor substrate.
